# EUROPEAN PATENT APPLICATION

(11) **EP 4 797 141 A1**
(43) Date of publication of application: **26.08.2026**
(21) Application number: 24879178.2
(22) Date of filing: 13.11.2024
(51) Int. Cl.: G06F 30/10

(54) **LAYOUT DIAGRAM GENERATION METHOD, APPARATUS, AND SYSTEM FOR PHOTOVOLTAIC POWER GENERATION SYSTEM, AND STORAGE MEDIUM**

(30) Priority: 19.10.2023 CN 202311369659
(71) Applicant: Hoymiles Power Electronics Inc., Hangzhou, Zhejiang 310015 (CN)
(72) Inventor: YU, Hongbin, Hangzhou, Zhejiang 310015 (CN); LI, Jun, Hangzhou, Zhejiang 310015 (CN); WANG, Jingming, Hangzhou, Zhejiang 310015 (CN); ZHAO, Yi, Hangzhou, Zhejiang 310015 (CN); YANG, Bo, Hangzhou, Zhejiang 310015 (CN)
(74) Representative: Meyer-Dulheuer MD Legal Patentanwälte PartG mbB
(86) International application number: PCT/CN2024/131814
(87) International publication number: WO 2025/082538

(57) **Abstract**

A layout diagram generation method, an apparatus, and a system for a photovoltaic power generation system, and a storage medium are provided. The layout diagram generation method includes: acquiring device information and first physical location information of each photovoltaic device; acquiring physical location information of each photovoltaic module and second physical location information of a photovoltaic device connected to the photovoltaic module; and generating a layout diagram of the photovoltaic power generation system based on the device information, the first physical location information, the second physical location information of each photovoltaic device, and the physical location information of each photovoltaic module. The first physical location information and the second physical location information of each photovoltaic device at least partially correspond to each other and at least include an arrangement number of the photovoltaic device in a photovoltaic device array.

## Description

### CROSS-REFERENCE TO RELATED APPLICATION

This application claims priority to Chinese patent application No. 202311369659.X, filed on October 19, 2023, and titled "LAYOUT DIAGRAM GENERATION METHOD, APPARATUS, AND SYSTEM FOR PHOTOVOLTAIC POWER GENERATION SYSTEM, AND STORAGE MEDIUM". The content of the above identified application is hereby incorporated herein in its entirety by reference.

### TECHNICAL FIELD

The present invention relates to the technical field of photovoltaic power generation, and in particular, to a layout diagram generation method, an apparatus, and a system for a photovoltaic power generation system, and a storage medium.

### BACKGROUND

A photovoltaic power generation system of a photovoltaic power station is composed of a plurality of photovoltaic modules and a plurality of photovoltaic devices groups. Each of the plurality of photovoltaic modules includes a plurality of photovoltaic cell substrings, and each of the plurality of photovoltaic devices groups is composed of a plurality of photovoltaic devices. Each photovoltaic device is connected to at least one photovoltaic cell substring. During operation and maintenance of the photovoltaic power station, faults are inevitable. When the photovoltaic power generation system has a fault, a technician can, through reports from the photovoltaic power generation system, use a reported product serial number of a photovoltaic device to look up, in a layout diagram of the photovoltaic power generation system, a physical location of a photovoltaic module bound to the product serial number, thereby allowing the technician to locate the photovoltaic device and the connected photovoltaic module for fault cause investigation.

In related technology, a corresponding label code (e.g., a two-dimensional code, a bar code, etc.) is typically attached to each photovoltaic device. During installation of the photovoltaic power generation system, an installer sequentially peels off the label codes of the photovoltaic devices and attaches the label codes onto a piece of paper marked with the physical locations of the corresponding photovoltaic modules. After all the photovoltaic modules are installed, the technician needs to manually scan the label codes on the paper one by one to obtain the product serial number of the photovoltaic device stored in each label code. In addition, the technician must manually bind each product serial number to the corresponding photovoltaic module to obtain a layout diagram. The method of the related technology is overly complicated, inefficient, and error-prone.

### SUMMARY

According to various embodiments of the present invention, a layout diagram generation method, an apparatus, and a system for a photovoltaic power generation system, and a storage medium are provided.

In a first aspect, a layout diagram generation method for a photovoltaic power generation system is provided in an embodiment of the present invention. The layout diagram generation method is applied to the photovoltaic power generation system. The photovoltaic power generation system includes at least one photovoltaic module and at least one photovoltaic device group. Each of the at least one photovoltaic module includes a plurality of photovoltaic cell substrings, and each of the at least one photovoltaic device group includes a plurality of photovoltaic devices each connected to at least one of the plurality of photovoltaic cell substrings. The layout diagram generation method includes: acquiring device information and first physical location information of each of the plurality of photovoltaic devices; acquiring physical location information of each of the at least one photovoltaic module and second physical location information of one of the plurality of photovoltaic devices connected to the photovoltaic module; and generating a layout diagram of the photovoltaic power generation system based on the device information, the first physical location information, the second physical location information of each of the plurality of photovoltaic devices, and the physical location information of each of the at least one photovoltaic module. The first physical location information and the second physical location information of each of the plurality of photovoltaic devices at least partially correspond to each other and at least include an arrangement number of the photovoltaic device in a photovoltaic device array.

In an embodiment, generating the layout diagram of the photovoltaic power generation system based on the device information, the first physical location information, the second physical location information of each of the plurality of photovoltaic devices, and the physical location information of each of the at least one photovoltaic module further includes: acquiring a mapping relationship between the device information of each of the plurality of photovoltaic devices and the physical location information of each of the at least one photovoltaic module based on a correspondence between first physical location information and second physical location information of the plurality of photovoltaic devices; and generating the layout diagram of the photovoltaic power generation system based on the mapping relationship, the device information of each of the plurality of photovoltaic devices, and the physical location information of each of the at least one photovoltaic module.

In an embodiment, generating the layout diagram of the photovoltaic power generation system based on the mapping relationship, the device information of each of the plurality of photovoltaic devices, and the physical location information of each of the at least one photovoltaic module further includes: determining at least one virtual unit corresponding to each of the plurality of photovoltaic devices in a layout diagram template based on the mapping relationship and the physical location information of each of the at least one photovoltaic module, one of the at least one virtual unit corresponding to one of the at least one photovoltaic module; and binding the device information of each of the plurality of photovoltaic devices with a corresponding one of the at least one virtual unit in the layout diagram template to obtain the layout diagram of the photovoltaic power generation system.

In an embodiment, while acquiring the physical location information of each of the at least one photovoltaic module and the second physical location information of one of the plurality of photovoltaic devices connected to the photovoltaic module, the layout diagram generation method further includes: acquiring connection information of each of the at least one photovoltaic module; generating the layout diagram of the photovoltaic power generation system based on the device information, the first physical location information, and the second physical location information of each of the plurality of photovoltaic devices, and the physical location information and the connection information of each of the at least one photovoltaic module. The connection information includes connection information between each of the at least one photovoltaic module and a port of a corresponding one of the plurality of photovoltaic devices.

In an embodiment, acquiring the physical location information of each of the at least one photovoltaic module and the second physical location information of one of the plurality of photovoltaic devices connected to the photovoltaic module further includes: acquiring the physical location information of each of the at least one photovoltaic module and the second physical location information of one of the plurality of photovoltaic devices connected to the photovoltaic module based on a design drawing of the photovoltaic power generation system.

In an embodiment, acquiring the device information and the first physical location information of each of the plurality of photovoltaic devices further includes: scanning device identifiers of the plurality of photovoltaic devices sequentially based on physical locations of the plurality of photovoltaic devices, to acquire the device information and the first physical location information of each of the plurality of photovoltaic devices.

In an embodiment, acquiring the device information and the first physical location information of each of the plurality of photovoltaic devices further includes: acquiring the device information and the first physical location information of each of the plurality of photovoltaic devices based on an identified information identification diagram of the photovoltaic power generation system. The information identification diagram includes at least one cell, and each of the at least one cell includes physical location information and a device identifier of a corresponding one of the plurality of photovoltaic devices.

In a second aspect, a layout diagram generation apparatus for a photovoltaic power generation system is provided in an embodiment of the present invention. The layout diagram generation apparatus is applied to the photovoltaic power generation system. The photovoltaic power generation system includes at least one photovoltaic module and at least one photovoltaic device group. Each of the at least one photovoltaic module includes a plurality of photovoltaic cell substrings, and each of the at least one photovoltaic device group includes a plurality of photovoltaic devices each connected to at least one of the plurality of photovoltaic cell substrings. The layout diagram generation apparatus includes a first acquisition module, a second acquisition module, and a generation module. The first acquisition module is configured for acquiring device information and first physical location information of each of the plurality of photovoltaic devices. The second acquisition module is configured for acquiring physical location information of each of the at least one photovoltaic module and second physical location information of one of the plurality of photovoltaic devices connected to the photovoltaic module. The first physical location information and the second physical location information of each of the plurality of photovoltaic devices at least partially correspond to each other and at least comprise an arrangement number of the photovoltaic device in a photovoltaic device array. The generation module is configured for generating a layout diagram of the photovoltaic power generation system based on the device information, the first physical location information, the second physical location information of each of the plurality of photovoltaic devices, and the physical location information of each of the at least one photovoltaic module.

In an embodiment, the generation module further includes a third acquisition module and a generation sub-module. The third acquisition module is configured for acquiring a mapping relationship between the device information of each of the plurality of photovoltaic devices and the physical location information of each of the at least one photovoltaic module based on a correspondence between first physical location information and second physical location information of the plurality of photovoltaic devices. The generation sub-module is configured for generating the layout diagram of the photovoltaic power generation system based on the mapping relationship, the device information of each of the plurality of photovoltaic devices, and the physical location information of each of the at least one photovoltaic module.

In an embodiment, the generation sub-module further includes a determination module and a binding module. The determination module is configured for determining at least one virtual unit corresponding to each of the plurality of photovoltaic devices in a layout diagram template based on the mapping relationship and the physical location information of each of the at least one photovoltaic module, and one of the at least one virtual unit is corresponding to one of the at least one photovoltaic module. The binding module is configured for binding the device information of each of the plurality of photovoltaic devices with a corresponding one of the at least one virtual unit in the layout diagram template to obtain the layout diagram of the photovoltaic power generation system.

In an embodiment, while acquiring the physical location information of each of the at least one photovoltaic module and the second physical location information of one of the plurality of photovoltaic devices connected to the photovoltaic module, the second acquisition module is further configured for acquiring connection information of each of the at least one photovoltaic module. The connection information includes connection information between each of the at least one photovoltaic module and a port of a corresponding one of the plurality of photovoltaic devices. The generation module is further configured for generating the layout diagram of the photovoltaic power generation system based on the device information, the first physical location information, and the second physical location information of each of the plurality of photovoltaic devices, and the physical location information and the connection information of each of the at least one photovoltaic module.

In an embodiment, the second acquisition module is further configured for acquiring the physical location information of each of the at least one photovoltaic module and the second physical location information of one of the plurality of photovoltaic devices connected to the photovoltaic module based on a design drawing of the photovoltaic power generation system.

In an embodiment, the first acquisition module is further configured for scanning device identifiers of the plurality of photovoltaic devices sequentially based on physical locations of the plurality of photovoltaic devices, to acquire the device information and the first physical location information of each of the plurality of photovoltaic devices.

In an embodiment, the first acquisition module is further configured for acquiring the device information and the first physical location information of each of the plurality of photovoltaic devices based on an identified information identification diagram of the photovoltaic power generation system. The information identification diagram includes at least one cell, and each of the at least one cell includes physical location information and a device identifier of a corresponding one of the plurality of photovoltaic devices.

In a third aspect, a layout diagram generation system is provided in an embodiment of the present invention. The layout diagram generation system includes at least one photovoltaic module, at least one photovoltaic device group, and the layout diagram generation apparatus as described in the second aspect. Each of the at least one photovoltaic module includes a plurality of photovoltaic cell substrings, and each of the at least one photovoltaic device group includes a plurality of photovoltaic devices each connected to at least one of the plurality of photovoltaic cell substrings.

In a fourth aspect, a computer readable storage medium having a computer program stored thereon is provided in an embodiment of the present invention. The computer program, when executed by a processor, implements steps of the layout diagram generation method as described in the first aspect.

Details of one or more embodiments of the present invention are presented in the attached drawings and descriptions below. And other features, purposes and advantages of the present invention will become apparent from the description, drawings, and claims.

### BRIEF DESCRIPTION OF THE DRAWINGS

To more clearly illustrate the technical solutions in the embodiments of the present invention or in the related art, the accompanying drawings used in the embodiments or the description of the related art will be briefly introduced below. The drawings in the following description are only some embodiments of the present invention. For those skilled in the art, other drawings may also be derived from these drawings without creative efforts.
FIG. 1 is a schematic structural diagram of a photovoltaic power generation system according to a first exemplary embodiment.
FIG. 2 is a schematic structural diagram of a photovoltaic power generation system according to a second exemplary embodiment.
FIG. 3 is a schematic structural diagram of a photovoltaic power generation system according to a third exemplary embodiment.
FIG. 4 is a schematic structural diagram of a photovoltaic power generation system according to a fourth exemplary embodiment.
FIG. 5 is a schematic structural diagram of a photovoltaic power generation system according to a fifth exemplary embodiment.
FIG. 6 is a schematic flowchart of a layout diagram generation method according to an embodiment.
FIG. 7 is a schematic flowchart of a layout diagram generation method according to an embodiment.
FIG. 8 is a specific flowchart of a layout diagram generation method according to an embodiment.
FIG. 9 is a schematic diagram of a physical layout of photovoltaic modules in the photovoltaic power generation system according to the first and second exemplary embodiments.
FIG. 10 is a schematic diagram of a physical layout of photovoltaic modules in the photovoltaic power generation system according to the third exemplary embodiment.
FIG. 11 is a schematic diagram of a physical layout of photovoltaic modules in the photovoltaic power generation system according to the fourth exemplary embodiment.
FIG. 12 is a schematic diagram of a physical layout of photovoltaic modules in the photovoltaic power generation system according to the fifth exemplary embodiment.
FIG. 13 is a schematic module connection diagram of a layout diagram generation apparatus according to an embodiment.

### DETAILED DESCRIPTION

To more clearly illustrate the technical solutions in the embodiments of the present invention, the accompanying drawings used in the embodiments or the description of the related art will be briefly introduced below. The drawings in the following description are only some embodiments of the present invention. For those skilled in the art, the present invention may also be applied to other similar scenarios according to these drawings without creative efforts. Unless apparent from the context of language or otherwise described, like reference numerals represent like structures or operations.

As shown in the description and the claims, unless the context clearly indicates otherwise, words such as "a", "an", "one", and/or "the" are not intended to refer specifically to the singular, but may also include the plural. Generally speaking, the terms "comprise" and "include" only indicate the inclusion of clearly identified steps and elements, and these steps and elements do not constitute an exclusive list, and the method or device may also include other steps or elements.

Although the present invention makes various references to certain modules in a system according to embodiments of the present invention, any number of different modules may be used and run on a computing device and/or processor. The modules are merely illustrative, and different aspects of the system and method may use different modules.

It should be understood that when a unit or module is described as being "connected", "coupled", to other units, modules, or blocks, it may refer to direct connection or coupling, or in communication with other units, modules, or blocks, or there may be intervening units, modules, or blocks, unless the context clearly dictates otherwise. As used herein, the term "and/or" may include any and all combinations of one or more of the associated listed items.

A photovoltaic power generation system is provided in an embodiment of the present invention. The photovoltaic power generation system includes at least one photovoltaic module and at least one photovoltaic device group. Each of the at least one photovoltaic module includes a plurality of photovoltaic cell substrings, and each of the at least one photovoltaic device group includes a plurality of photovoltaic devices each connected to at least one of the plurality of photovoltaic cell substrings.

Each photovoltaic module includes a plurality of photovoltaic cell substrings. In some embodiments, the plurality of photovoltaic cell substrings may be connected to the photovoltaic devices, respectively. In other embodiments, the plurality of photovoltaic cell substrings may be connected in series/parallel and then connected, on a module basis, to the photovoltaic devices.

In some embodiments, the photovoltaic power generation system may further include at least one convergence device connected to the at least one photovoltaic device group. The convergence device may be configured to ensure orderly connection of the at least one photovoltaic device group and to perform a convergence function.

The convergence device may include, for example, an (alternate current) AC convergence box, a (direct current) DC convergence box, an inverter, or the like.

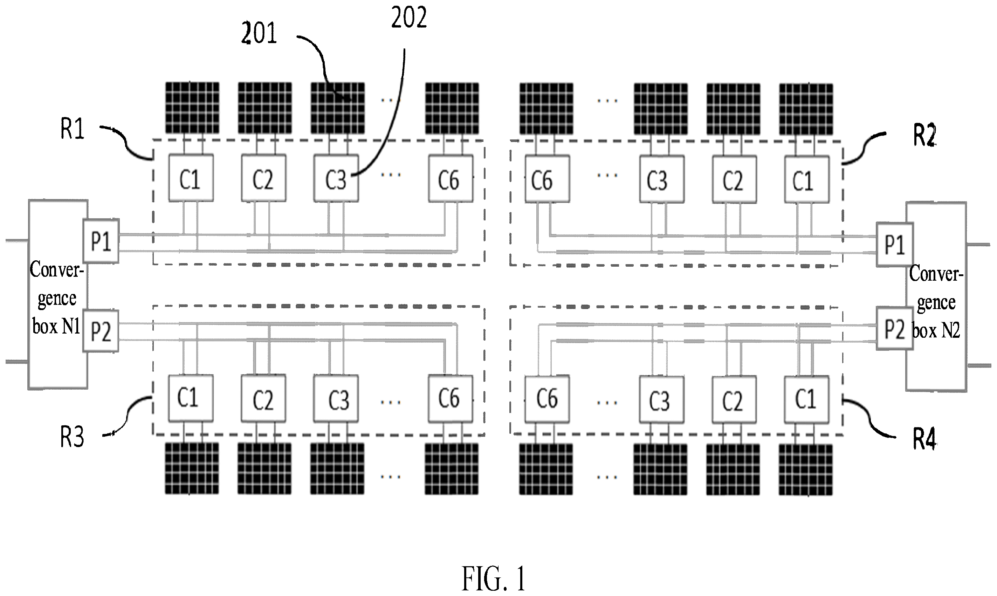

FIG. 1 is a schematic structural diagram of a photovoltaic power generation system according to a first exemplary embodiment. The photovoltaic power generation system may include a management module (not shown), a first convergence box H1, a second convergence box H2, a plurality of photovoltaic modules 201, and a plurality of photovoltaic devices groups R1, R2, R3, and R4 connected to the convergence boxes. Each of the plurality of photovoltaic devices groups includes a plurality of photovoltaic devices 202 each connected to at least one of the plurality of photovoltaic modules 201. The management module may be implemented by using a controller or the like.

In some embodiments, the photovoltaic module 201 may include a photovoltaic panel. Alternatively, the photovoltaic device 202 may be a micro-inverter. That is, each photovoltaic module 201 is separately provided with an inverter module having an AC/DC conversion function and a maximum power point tracking function, such that and electric energy generated by the photovoltaic module can be directly converted into AC electric energy for use by an AC load or for transmission to a power grid.

The photovoltaic module 201 may be configured to convert solar radiant energy into DC electrical energy. The photovoltaic device 202 may be configured to regulate an output state of the corresponding photovoltaic module 201, and directly convert the electrical energy generated by the photovoltaic module 201 into AC electrical energy. The convergence box may be a wiring device that ensures orderly connection of the photovoltaic device groups and performs the convergence function. A plurality of photovoltaic devices in the same photovoltaic device group may be connected in parallel, and the plurality of photovoltaic devices groups may be connected to a plurality of input ports of the convergence box, respectively. The management module may be configured to communicate with each photovoltaic device 202. It may be understood that in other embodiments, the plurality of photovoltaic devices 202 in one photovoltaic device group may also be connected in series.

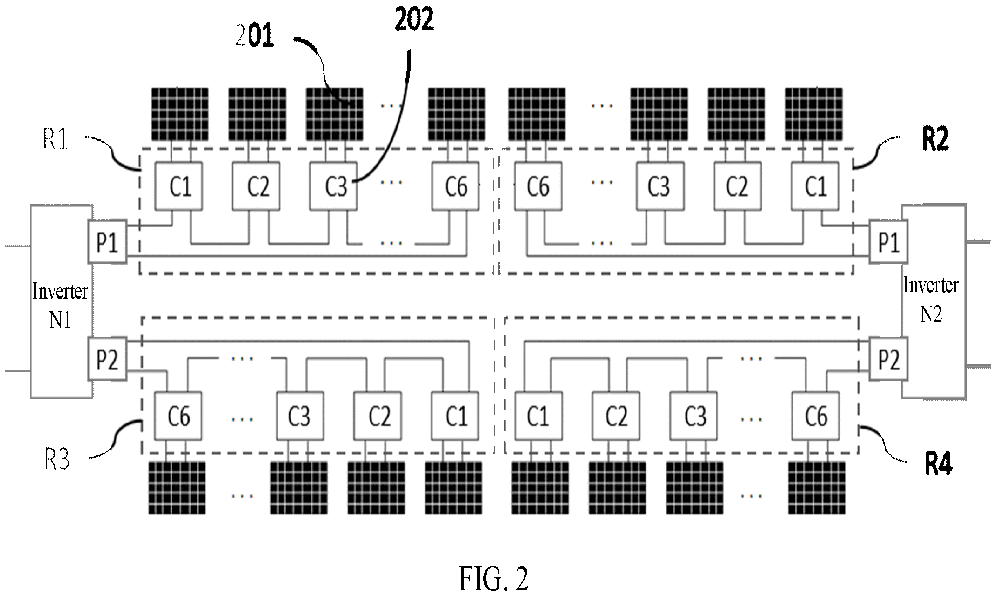

FIG. 2 is a schematic structural diagram of a photovoltaic power generation system according to a second exemplary embodiment. The photovoltaic power generation system may include a management module (not shown), a first inverter N1, a second inverter N2, a plurality of photovoltaic modules 201, and a plurality of photovoltaic devices groups R1, R2, R3, and R4 connected to the inverters. Each of the plurality of photovoltaic devices groups R1, R2, R3, and R4 may include a plurality of photovoltaic devices 202 each connected to at least one of the plurality of photovoltaic modules 201.

In some embodiments, the photovoltaic module 201 may include a photovoltaic panel. Alternatively, the photovoltaic device 202 may have one or more of the following functions: regulating an output power of the photovoltaic module 201 (in which case the photovoltaic device may also be referred to as an optimizer), controlling the start or stop of output of the photovoltaic module 201 (in which case the photovoltaic device may also be referred to as a disconnector), and monitoring an output state of the photovoltaic module 201 (in which case the photovoltaic device may also be referred to as a monitor). For example, the photovoltaic device 202 may be configured to regulate a voltage amplitude and a current amplitude of the DC electrical energy output by the photovoltaic module 201, such that an output power of the photovoltaic module 201 reaches a maximum power, thereby improving utilization of the photovoltaic module 201.

The photovoltaic module 201 may be configured to convert solar radiant energy into DC electrical energy. The photovoltaic device 202 may be configured to regulate an output state of the corresponding photovoltaic module 201. The inverter may be configured to invert the DC electrical energy provided by the photovoltaic module 201 into AC electrical energy and output the AC electrical energy. A plurality of photovoltaic devices in the same photovoltaic device group may be connected in series, and the plurality of photovoltaic devices may be connected to a plurality of DC input ports of the inverter, respectively. The management module may be configured to communicate with each photovoltaic device 202.

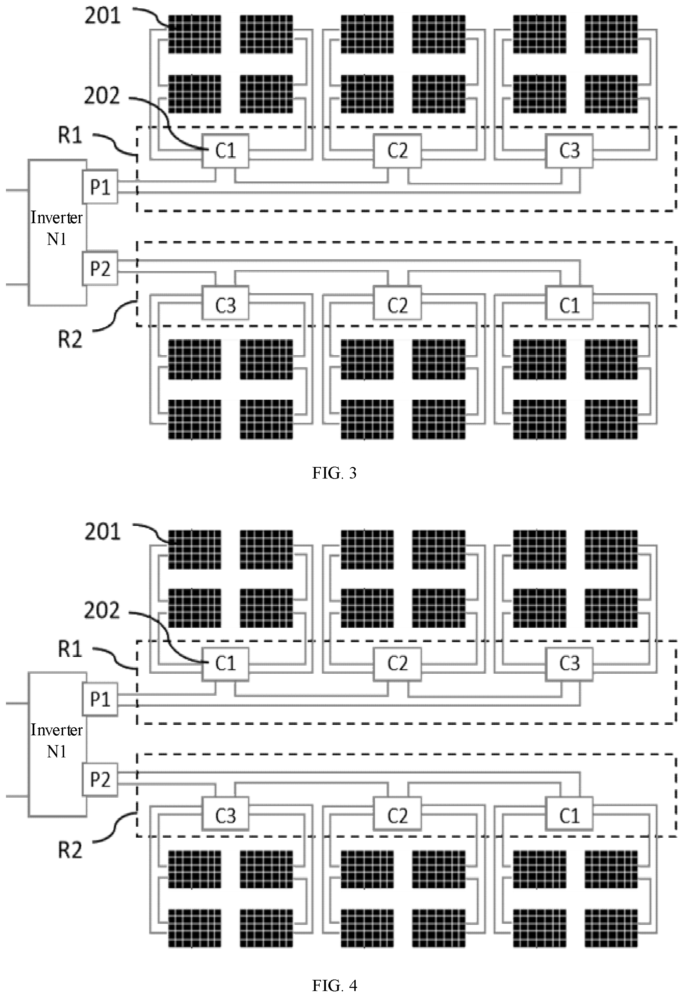

FIG. 3 is a schematic structural diagram of a photovoltaic power generation system according to a third exemplary embodiment. The photovoltaic power generation system in FIG. 3 shows only an inverter N1, and photovoltaic device groups R1 and R2 connected to input ports P1 and P2 of the inverter, respectively. Each photovoltaic device group may include a plurality of photovoltaic devices 202 connected to two photovoltaic modules 201, respectively. As shown in FIG. 3, two photovoltaic modules 201 may be connected to two ports of the photovoltaic device 202, respectively.

It will be appreciated that each photovoltaic device may have three or more ports to be connected to three or more photovoltaic modules.

FIG. 4 is a schematic structural diagram of a photovoltaic power generation system according to a fourth exemplary embodiment. The photovoltaic power generation system in FIG. 4 shows only an inverter N1, and photovoltaic device groups R1 and R2 connected to input ports P1 and P2 of the inverter, respectively. Each photovoltaic device group may include a plurality of photovoltaic devices 202 connected to four photovoltaic modules 201, respectively. As shown in FIG. 3, every two photovoltaic modules 201 may be connected to one port of the photovoltaic device 202, and the two photovoltaic modules 201 connected to one port may be connected in series. It may be understood that in other embodiments, two or more photovoltaic modules connected to each port of the photovoltaic device may also be connected in parallel.

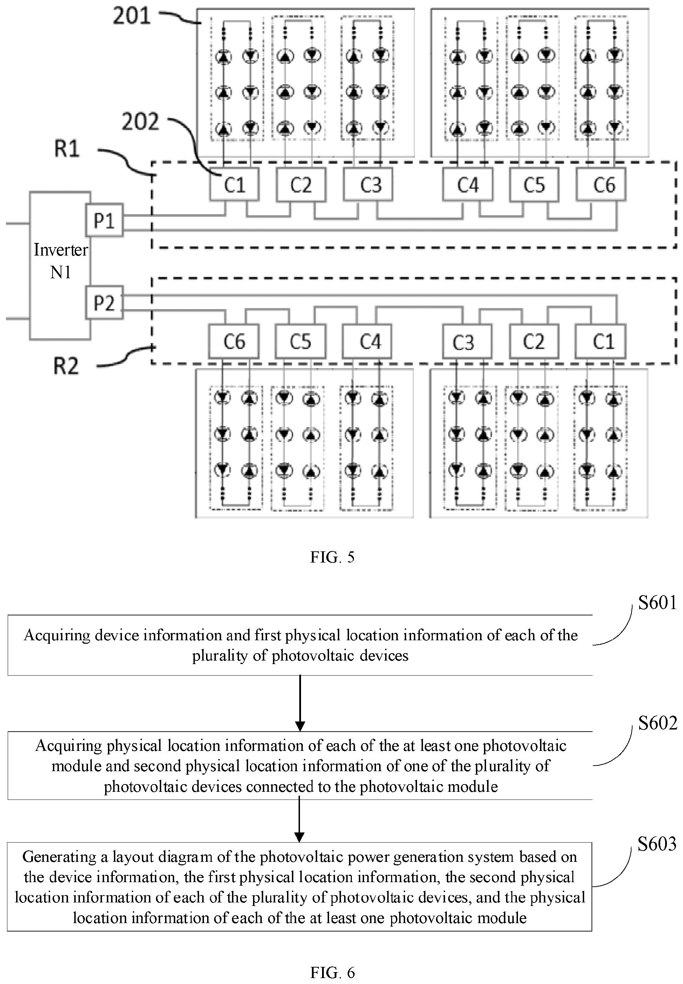

FIG. 5 is a schematic structural diagram of a photovoltaic power generation system according to a fifth exemplary embodiment. The photovoltaic power generation system in FIG. 5 shows only an inverter N1, and photovoltaic device groups R1 and R2 connected to input ports P1 and P2 of the inverter, respectively. Each photovoltaic device group may include a plurality of photovoltaic devices 202 each connected to photovoltaic cell substrings of the photovoltaic module 201. As shown in FIG. 5, each photovoltaic module 201 may include three photovoltaic cell substrings each connected to one photovoltaic device 202 in series, and the plurality of photovoltaic devices in one photovoltaic device group may be connected in series. It may be understood that in other embodiments, each photovoltaic module may include two or more photovoltaic cell substrings. One photovoltaic device may be connected to two or more photovoltaic cell substrings, and the plurality of photovoltaic devices in one photovoltaic device group may be connected in parallel.

In FIG. 1 to FIG. 5, each photovoltaic device may have corresponding electrical location information. The electrical location information of the photovoltaic device may include at least a group number of a photovoltaic device group to which the photovoltaic device belongs and positional ranking information of the photovoltaic device in the photovoltaic device group to which the photovoltaic device belongs. Each photovoltaic device group may have a group number, e.g., R1, R2, R3, R4, etc. Furthermore, a group number of a photovoltaic device group may be represented by the number of the convergence device to which the photovoltaic device group is connected and the port number of the convergence device, e.g., N1-P1, N1-P2, etc. The positional ranking information of the photovoltaic devices in the photovoltaic device group to which the photovoltaic devices belong may include, e.g., in FIG. 1, C1, C2, ..., C6, etc. arranged sequentially from a photovoltaic device closest to the port of the convergence device to a photovoltaic device farthest from the port in the photovoltaic device group; or in FIG. 2 to FIG. 5, C1, C2, ..., C6, etc. arranged sequentially from a positive pole to a negative pole of the photovoltaic device group.

Each photovoltaic device may have corresponding physical location information. The physical location information may include at least an arrangement number of the photovoltaic device. A photovoltaic device may be installed on a back side or a frame of a corresponding photovoltaic module and electrically connected to all corresponding photovoltaic modules. Alternatively, a photovoltaic device may be installed on another position such as a mounting rail and electrically connected to all corresponding photovoltaic modules. It may be understood that all photovoltaic devices in the photovoltaic power generation system may form a photovoltaic device array. The photovoltaic device array may include a plurality of rows of photovoltaic devices. Each of photovoltaic devices in each row of photovoltaic devices may have a corresponding positional ranking. The arrangement number of the photovoltaic device may indicate physical location information of the photovoltaic device. For example, 1-1 may indicate that the photovoltaic device is located at a first position in a first row of photovoltaic devices.

Each photovoltaic device may have corresponding device information. The device information of the photovoltaic device may include a unique identifier such as a product serial number of the photovoltaic device. A carrier of the device information, i.e., the device identifier, may be a two-dimensional code provided on the photovoltaic device, and the device information of the photovoltaic device may be acquired by identifying the two-dimensional code. It may be understood that the device identifier is not limited to a two-dimensional code, or may be a one-dimensional code or other forms of information carrier or label code.

Each photovoltaic module may have corresponding physical location information. The plurality of photovoltaic modules in the photovoltaic power generation system may form a photovoltaic module array. The physical location information of the photovoltaic module may include row and column numbers of the photovoltaic module, to indicate a row and column location of the photovoltaic module in the photovoltaic module array. For example, 1-1 may indicate that the photovoltaic module is located at the first row and the first column. In a case where the photovoltaic power generation system includes a plurality of photovoltaic module arrays, the physical location information of the photovoltaic module may further include orientation information of the photovoltaic module array to which the photovoltaic module belongs. For example, ES-1-1 may indicate that the photovoltaic module is located at the first row and the first column in the photovoltaic module array facing southeast, and NS-1-1 may indicate that the photovoltaic module is located at the first row and the first column in the photovoltaic module array facing southwest. In some other embodiments, the physical location information of the photovoltaic module may further include information such as an azimuth angle, a tilt angle, and an orientation of the photovoltaic module.

A layout diagram generation method for a photovoltaic power generation system is provided in the present invention. As shown in FIG. 6, The layout diagram generation method includes steps 601 to 603.

Step 601 includes acquiring device information and first physical location information of each of the plurality of photovoltaic devices.

The first physical location information of the photovoltaic device may include physical location information of the photovoltaic device.

The device information and the first physical location information of each of the plurality of photovoltaic devices may be acquired by scanning device identifiers of the plurality of photovoltaic devices in an order of physical locations of the photovoltaic devices.

The device information and the first physical location information of each of the plurality of photovoltaic devices may also be acquired based on an identified information identification diagram of the photovoltaic power generation system. The information identification diagram includes at least one cell, and each of the at least one cell includes physical location information and a device identifier of a corresponding one of the plurality of photovoltaic devices.

Step 602 includes acquiring physical location information of each of the at least one photovoltaic module and second physical location information of one of the plurality of photovoltaic devices connected to the photovoltaic module.

The first physical location information and the second physical location information of each of the plurality of photovoltaic devices at least partially correspond to each other. Each of the first physical location information and the second physical location information of the photovoltaic device at least includes an arrangement number of the photovoltaic device in the photovoltaic device array.

The physical location information of each of the at least one photovoltaic module and the second physical location information of one of the plurality of photovoltaic devices connected to the photovoltaic module may be acquired by using a design drawing of the photovoltaic power generation system.

For example, the design drawing of the photovoltaic power generation system may be a computer-aided design (CAD) drawing, and the design drawing may include a correspondence between the physical location information of the photovoltaic module and second physical location information. Generally, such a CAD image may be retained after the photovoltaic power station is constructed and can be directly obtained. In an embodiment, the physical locations of the photovoltaic modules may be depicted in the CAD image, one rectangular box may represent one photovoltaic module, and row and column locations of the rectangular box in the CAD image may represent the physical location information of the photovoltaic module. For example, the physical location information of the photovoltaic module corresponding to the rectangular box at the first row and the first column may be 1-1. Moreover, the second physical location information of the corresponding photovoltaic device may be displayed on each rectangular box. For example, the second physical location information of the photovoltaic device may be marked according to the arrangement number. In some embodiments, the second physical location information of the photovoltaic device may be numbered during the design of the photovoltaic power generation system, and the number may be marked in the design drawing, and thus it is only necessary to identify the number. For example, in the photovoltaic module located at the first row and first column, a number 1-1 may indicate that the photovoltaic device connected to the photovoltaic module is located at the first position in the first row of photovoltaic devices in the photovoltaic device array. Therefore, the physical location information of each photovoltaic module and the second physical location information of the connected photovoltaic device may be acquired based on the design drawing.

In other embodiments, the design drawing of the photovoltaic power generation system may be generated by professional design software, which can automatically perform layout based on station constructing conditions of the photovoltaic power generation system. The physical location information of each photovoltaic module and the second physical location information of the connected photovoltaic device may be directly derived based on the design drawing generated by the professional design software.

Step 603 includes generating a layout diagram of the photovoltaic power generation system based on the device information, the first physical location information, the second physical location information of each of the plurality of photovoltaic devices, and the physical location information of each of the at least one photovoltaic module.

Each virtual unit in the layout diagram may include or implicitly include the physical location information of a corresponding photovoltaic module and the device information of a photovoltaic device connected to the corresponding photovoltaic module.

For example, the physical location information of the photovoltaic module may be represented by characters, or may be represented by position information of a corresponding virtual unit in the layout diagram.

For example, the physical location information of the photovoltaic module corresponding to the virtual unit at the first row and the first column may be represented as 1-1, and thus it is not necessary to represent the physical location information of the photovoltaic module with characters on the virtual unit.

It may be understood that based on the correspondence between the first physical location information and the second physical location information, the device information of the photovoltaic device corresponding to the physical location information of each photovoltaic module may be determined, then, based on the device information of each photovoltaic device and the physical location information of each photovoltaic module, the layout diagram of the photovoltaic power generation system may be acquired.

Based on steps 601 to 603, the device information and the first physical location information of each photovoltaic device are acquired; the physical location information of each photovoltaic module and the second physical location information of the photovoltaic device connected to the photovoltaic module are acquired; and the layout diagram of the photovoltaic power generation system are generated based on the device information, the first physical location information, and the second physical location information of the photovoltaic devices, and the physical location information of the photovoltaic modules. According to the present embodiment, the layout diagram of the photovoltaic power generation system is generated based on the acquired physical location information and the device information of the photovoltaic devices in one-to-one correspondence and the acquired physical location information of the photovoltaic devices and the corresponding physical location information of the photovoltaic modules. Thus, the accuracy of generating the layout diagram is improved, and the installation efficiency and the operation and maintenance efficiency of the photovoltaic power generation system are improved.

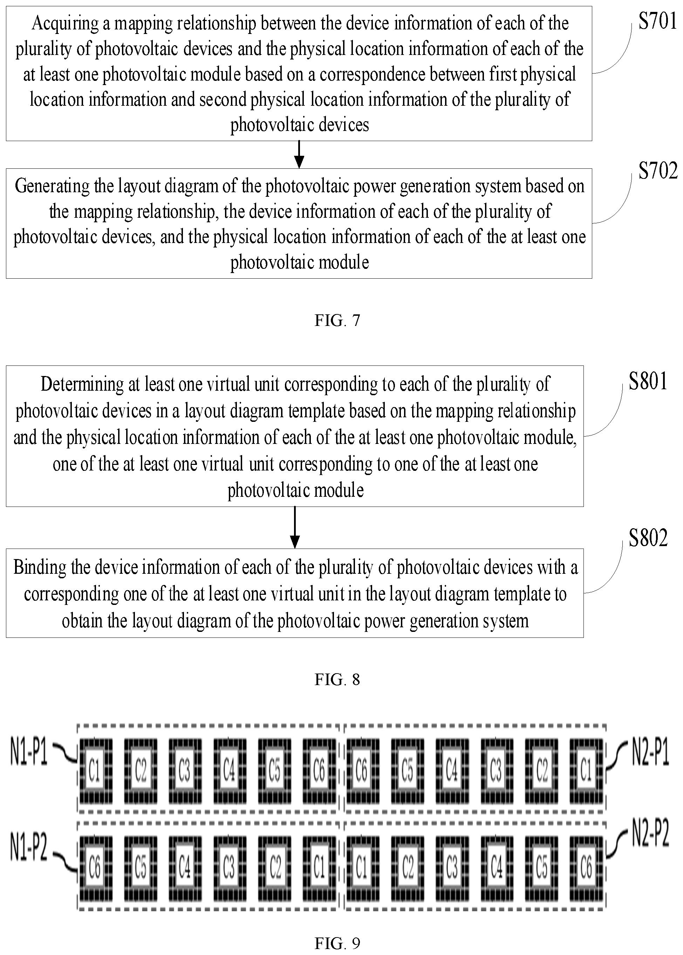

In an embodiment, as shown in FIG. 7, generating the layout diagram of the photovoltaic power generation system based on the device information, the first physical location information, the second physical location information of each of the plurality of photovoltaic devices, and the physical location information of each of the at least one photovoltaic module may further include the following steps 701 to 702.

Step 701 may include acquiring a mapping relationship between the device information of each of the plurality of photovoltaic devices and the physical location information of each of the at least one photovoltaic module based on a correspondence between first physical location information and second physical location information of the plurality of photovoltaic devices.

Step 702 may include generating the layout diagram of the photovoltaic power generation system based on the mapping relationship, the device information of each of the plurality of photovoltaic devices, and the physical location information of each of the at least one photovoltaic module.

The mapping relationship may include a connection relationship between each photovoltaic device and each photovoltaic module. The device information of corresponding photovoltaic device connected to each photovoltaic module can be determined according to the mapping relationship, and the physical location information of the photovoltaic modules may be associated with the virtual units in the layout diagram, thereby enabling the generation of the layout diagram of the photovoltaic power generation system.

In an embodiment, as shown in FIG. 8, generating the layout diagram of the photovoltaic power generation system based on the mapping relationship, the device information of each of the plurality of photovoltaic devices, and the physical location information of each of the at least one photovoltaic module may further include steps 801 to 802.

Step 801 may include determining at least one virtual unit corresponding to each of the plurality of photovoltaic devices in a layout diagram template based on the mapping relationship and the physical location information of each of the at least one photovoltaic module, one of the at least one virtual unit corresponding to one of the at least one photovoltaic module.

Step 802 may include binding the device information of each of the plurality of photovoltaic devices with a corresponding one of the at least one virtual unit in the layout diagram template to obtain the layout diagram of the photovoltaic power generation system.

The layout diagram template may be drawn with a table. The entire table may represent a photovoltaic module array, and each cell of the table may represent one virtual unit, with one virtual unit corresponding to one photovoltaic module of the photovoltaic module array. The layout diagram template may be generated based on the physical location information of each photovoltaic module acquired from the design drawing.

Each row of the table of the layout diagram template may have a number, e.g., 1, 2, 3, ..., and each column may also have a number, e.g., 1, 2, 3, .... The physical location information of any cell in the table can be represented by the row and column numbers. For example, the physical location information of the cell at the first row and first column in the layout diagram template can be represented as 1-1, meaning that the virtual unit with the physical location information 1-1 may correspond to a photovoltaic module located at the first row and the first column in the photovoltaic module array.

According to the mapping relationship, i.e., the connection relationship between each photovoltaic device and each photovoltaic module in the photovoltaic power generation system, the photovoltaic device corresponding to each cell in the layout diagram template can be determined, and thus the device information of each photovoltaic device can be associated. By binding the device information of each photovoltaic device with the corresponding at least one virtual unit in the layout diagram template, the layout diagram of the photovoltaic power generation system can be obtained.

In an exemplary embodiment, as shown in FIG. 1 and FIG. 2, each photovoltaic device may be connected to one photovoltaic module. The acquired device information and the first physical location information of each photovoltaic device may be stored in a result list. As shown in Table 1, the device information and the corresponding first physical location information of the photovoltaic device may be stored in a same row of the result list.

**Table 1**

| Device Information of Photovoltaic Device | First Physical Location Information of Photovoltaic Device |
|---|---|
| XXXXXX01 | 1-1 |
| XXXXXX02 | 1-2 |
| XXXXXX03 | 1-3 |
| XXXXXX04 | 1-4 |
| XXXXXX05 | 1-5 |
| XXXXXX06 | 1-6 |
| XXXXXX07 | 1-7 |
| XXXXXX08 | 1-8 |
| XXXXXX09 | 1-9 |
| XXXXXX10 | 1-10 |
| XXXXXX11 | 1-11 |
| XXXXXX12 | 1-12 |
| XXXXXX13 | 2-1 |
| XXXXXX14 | 2-2 |
| XXXXXX15 | 2-3 |
| XXXXXX16 | 2-4 |
| XXXXXX17 | 2-5 |
| XXXXXX18 | 2-6 |
| XXXXXX19 | 2-7 |
| XXXXXX20 | 2-8 |
| XXXXXX21 | 2-9 |
| XXXXXX22 | 2-10 |
| XXXXXX23 | 2-11 |
| XXXXXX24 | 2-12 |

Referring to Table 2, the physical location information of each photovoltaic module and the second physical location information of the photovoltaic device connected to the photovoltaic module may be stored in an information list, and the physical location information of the photovoltaic module and the second physical location information of the photovoltaic device may be stored in a same row of the information list. Thus, the physical location information of the photovoltaic module may be associated with the second physical location information of the photovoltaic device. As shown in FIG. 9, a photovoltaic device may be installed on a back side of the corresponding photovoltaic module and electrically connected to the photovoltaic module, so that the physical location information of the photovoltaic modules may be in a one-to-one correspondence with the second physical location information of the photovoltaic devices.

**Table 2**

| Physical Location Information of Photovoltaic Module | Second Physical Location Information of Photovoltaic Device |
|---|---|
| 1-1 | 1-1 |
| 1-2 | 1-2 |
| 1-3 | 1-3 |
| 1-4 | 1-4 |
| 1-5 | 1-5 |
| 1-6 | 1-6 |
| 1-7 | 1-7 |
| 1-8 | 1-8 |
| 1-9 | 1-9 |
| 1-10 | 1-10 |
| 1-11 | 1-11 |
| 1-12 | 1-12 |
| 2-1 | 2-1 |
| 2-2 | 2-2 |
| 2-3 | 2-3 |
| 2-4 | 2-4 |
| 2-5 | 2-5 |
| 2-6 | 2-6 |
| 2-7 | 2-7 |
| 2-8 | 2-8 |
| 2-9 | 2-9 |
| 2-10 | 2-10 |
| 2-11 | 2-11 |
| 2-12 | 2-12 |

According to Table 1 and Table 2, the mapping relationship between each photovoltaic device and each photovoltaic module may be determined based on the correspondence between the first physical location information and the second physical location information of the photovoltaic devices. Based on the mapping relationship, at least one virtual unit in the layout diagram template corresponding to each photovoltaic device may be determined. For example, a photovoltaic device having physical location information 1-1 may have a mapping relationship with a photovoltaic module having the physical location information 1-1, such that it can be determined that the photovoltaic device having the physical location information 1-1 may be corresponding to the cell with 1-1 in the layout diagram template. The device information of the photovoltaic device with the physical location information 1-1 may be represented as XXXXXX01, and the device information may be filled into the cell with 1-1 in the layout diagram template. The same binding operation may be performed for other photovoltaic devices to obtain the layout diagram as shown in Table 3.

**Table 3**

| | | | | | | | | | | | |
|---|---|---|---|---|---|---|---|---|---|---|---|
| xxxxx x 01 | xxxxx x 02 | xxxxx x 03 | xxxxx x 04 | xxxxx x 05 | xxxxx x 06 | xxxxx x 07 | xxxxx x 08 | xxxxx x 09 | xxxxx x 10 | xxxxx x 11 | xxxxx x 12 |
| xxxxx x 13 | xxxxx x 14 | xxxxx x 15 | xxxxx x 16 | xxxxx x 17 | xxxxx x 18 | xxxxx x 19 | xxxxx x 20 | xxxxx x 21 | xxxxx x 22 | xxxxx x 23 | xxxxx x 24 |

In an exemplary embodiment, each photovoltaic device may be connected to more than one photovoltaic module. As shown in FIG. 3, taking the case where each photovoltaic device is connected to two photovoltaic modules as an example for illustration. The acquired device information and first physical location information of each photovoltaic device may be stored in a result list. As shown in Table 4, the device information and the corresponding first physical location information of the photovoltaic device may be stored in a same row of the result list.

**Table 4**

| Device Information of Photovoltaic Device | First Physical Location Information of Photovoltaic Device |
|---|---|
| XXXXXX01 | 1-1 |
| XXXXXX02 | 1-2 |
| XXXXXX03 | 1-3 |
| XXXXXX04 | 2-1 |
| XXXXXX05 | 2-2 |
| XXXXXX06 | 2-3 |

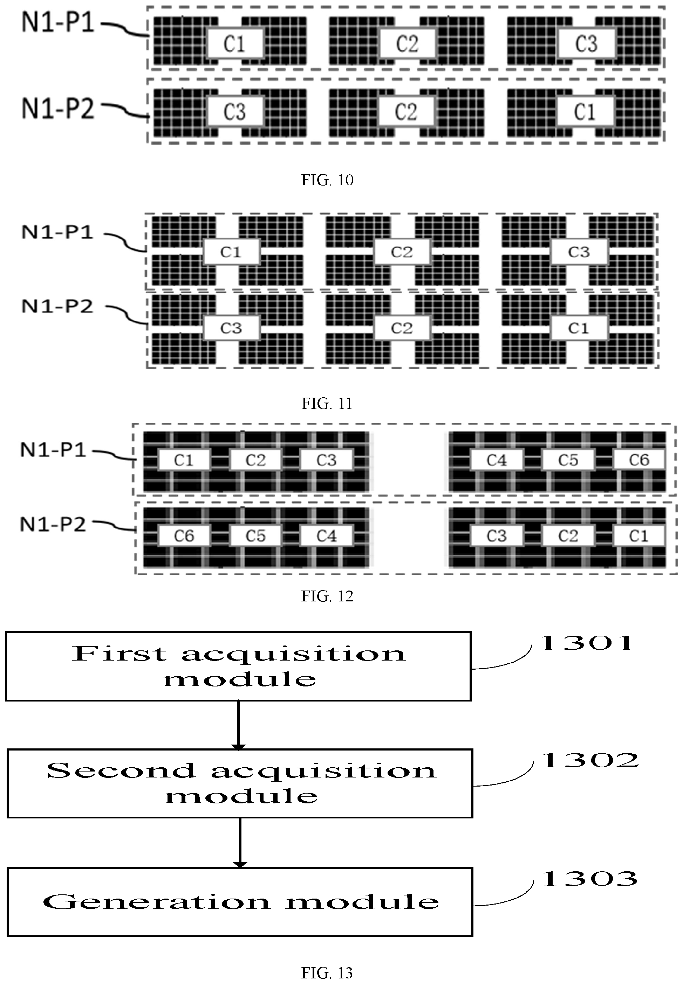

Referring to Table 5, the physical location information of each photovoltaic module and the second physical location information of the photovoltaic device connected to the photovoltaic module may be stored in an information list, with the physical location information of the photovoltaic module and the second physical location information of the photovoltaic device stored in the same row of the information list. Thus, the physical location information of the photovoltaic module may be associated with the second physical location information of the photovoltaic device. As shown in FIG. 10, the photovoltaic device may be installed on a mounting rail between two corresponding photovoltaic modules and electrically connected to the two photovoltaic modules, such that physical location information of the two photovoltaic modules may be corresponding to the second physical location information of the same photovoltaic device.

**Table 5**

| Physical location information of photovoltaic module | Second Physical Location Information of the Photovoltaic Device |
|---|---|
| 1-1 | 1-1 |
| 1-2 | 1-1 |
| 1-3 | 1-2 |
| 1-4 | 1-2 |
| 1-5 | 1-3 |
| 1-6 | 1-3 |
| 2-1 | 2-1 |
| 2-2 | 2-1 |
| 2-3 | 2-2 |
| 2-4 | 2-2 |
| 2-5 | 2-3 |
| 2-6 | 2-3 |

According to Table 4 and Table 5, the matching first physical location information and second physical location information of the photovoltaic devices may be found, thereby establishing a mapping relationship between the photovoltaic devices and the photovoltaic modules. Therefore, by associating the device information of the photovoltaic devices with the physical location information of the photovoltaic modules, a layout diagram as shown in Table 6 can be obtained.

**Table 6**

| | | | | | |
|---|---|---|---|---|---|
| xxxxxx 01 | xxxxxx 01 | xxxxxx 02 | xxxxxx 02 | xxxxxx 03 | xxxxxx 03 |
| xxxxxx 04 | xxxxxx 04 | xxxxxx 05 | xxxxxx 05 | xxxxxx 06 | xxxxxx 06 |

In some implementations, the connection information of the photovoltaic modules may also be embodied in the layout diagram shown in Table 6, for example, in a form of "XXXXXX01-1" and "XXXXXX01-2" in cells of the first row, first column and the first row, second column, respectively, to indicate that the photovoltaic module corresponding to the cell may be connected to a port 1 and a port 2 of the corresponding photovoltaic device, respectively.

In an exemplary embodiment, each input port of each photovoltaic device may be connected to more than one photovoltaic module. As shown in FIG. 4, taking a case where each photovoltaic device has two input ports and each input port is connected to two photovoltaic modules as an example for illustration. The acquired device information and first physical location information of each photovoltaic device may be stored in a result list. As shown in Table 7, the device information and the corresponding first physical location information of the photovoltaic device may be stored in the same row of the result list.

**Table 7**

| Device Information of Photovoltaic Device | First Physical Location Information of Photovoltaic Device |
|---|---|
| XXXXXX01 | 1-1 |
| XXXXXX02 | 1-2 |
| XXXXXX03 | 1-3 |
| XXXXXX04 | 2-1 |
| XXXXXX05 | 2-2 |
| XXXXXX06 | 2-3 |

**Table 8**

| Physical Location Information of Photovoltaic Module | Second Physical Location Information of Photovoltaic Device |
|---|---|
| 1-1 | 1-1 |
| 1-2 | 1-1 |
| 1-3 | 1-2 |
| 1-4 | 1-2 |
| 1-5 | 1-3 |
| 1-6 | 1-3 |
| 2-1 | 1-1 |
| 2-2 | 1-1 |
| 2-3 | 1-2 |
| 2-4 | 1-2 |
| 2-5 | 1-3 |
| 2-6 | 1-3 |
| 3-1 | 2-1 |
| 3-2 | 2-1 |
| 3-3 | 2-2 |
| 3-4 | 2-2 |
| 3-5 | 2-3 |
| 3-6 | 2-3 |
| 4-1 | 2-1 |
| 4-2 | 2-1 |
| 4-3 | 2-2 |
| 4-4 | 2-2 |
| 4-5 | 2-3 |
| 4-6 | 2-3 |

Referring to Table 8, the physical location information of each photovoltaic module and the second physical location information of the photovoltaic device connected to the photovoltaic module may be stored in an information list, with the physical location information of the photovoltaic module and the second physical location information of the photovoltaic device stored in the same row of the information list. Thus, the physical location information of the photovoltaic modules may be associated with the second physical location information of the photovoltaic devices. As shown in FIG. 11, a photovoltaic device may be installed on a mounting rail between four corresponding photovoltaic modules and electrically connected to the four photovoltaic modules, such that the physical location information of the four photovoltaic modules may be corresponding to the second physical location information of the same photovoltaic device.

According to Table 7 and Table 8, the matching first physical location information and second physical location information of the photovoltaic device may be found, thereby establishing a mapping relationship between the photovoltaic devices and the photovoltaic modules. Therefore, by associating the device information of the photovoltaic devices with the physical location information of the photovoltaic modules, a layout diagram as shown in Table 9 can be obtained.

**Table 9**

| | | | | | |
|---|---|---|---|---|---|
| xxxxxx 01 | xxxxxx 01 | xxxxxx 02 | xxxxxx 02 | xxxxxx 03 | xxxxxx 03 |
| xxxxxx 01 | xxxxxx 01 | xxxxxx 02 | xxxxxx 02 | xxxxxx 03 | xxxxxx 03 |
| xxxxxx 04 | xxxxxx 04 | xxxxxx 05 | xxxxxx 05 | xxxxxx 06 | xxxxxx 06 |
| xxxxxx 04 | xxxxxx 04 | xxxxxx 05 | xxxxxx 05 | xxxxxx 06 | xxxxxx 06 |

In some embodiments, the connection information of the photovoltaic modules may also be embodied in the layout diagram shown in Table 9, for example, in a form of "XXXXXX01-1-2" and "XXXXXX01-1-1" in cells of the first row, first column and the second row, first column, respectively, to indicate photovoltaic modules corresponding to the cell may include the second and first photovoltaic modules connected to a port 1 of the corresponding photovoltaic device.

In an exemplary embodiment, each photovoltaic device may be connected to one photovoltaic cell substring of a photovoltaic module. As shown in FIG. 5, taking a case where each photovoltaic module includes three photovoltaic cell substrings each connected to one photovoltaic device as an example for illustration. The acquired device information and first physical location information of each photovoltaic device may be stored in a result list. As shown in Table 10, the device information and the corresponding first physical location information of the photovoltaic device may be stored in the same row of the result list.

**Table 10**

| Device Information of Photovoltaic Device | First Physical Location Information of Photovoltaic Device |
|---|---|
| XXXXXX01 | 1-1 |
| XXXXXX02 | 1-2 |
| XXXXXX03 | 1-3 |
| XXXXXX04 | 1-4 |
| XXXXXX05 | 1-5 |
| XXXXXX06 | 1-6 |
| XXXXXX07 | 2-1 |
| XXXXXX08 | 2-2 |
| XXXXXX09 | 2-3 |
| XXXXXX10 | 2-4 |
| XXXXXX11 | 2-5 |
| XXXXXX12 | 2-6 |

Referring to Table 11, the physical location information of each photovoltaic module and the second physical location information of the photovoltaic devices connected to the photovoltaic module may be stored in an information list, with the physical location information of the photovoltaic module and the second physical location information of the photovoltaic device stored in the same row of the information list. Thus, the physical location information of the photovoltaic modules may be associated with the second physical location information of the photovoltaic devices. As shown in FIG. 12, three photovoltaic devices may be installed on a back side of a corresponding photovoltaic module and electrically connected to the photovoltaic module, such that the physical location information of one photovoltaic module may be corresponding to the second physical location information of the three photovoltaic devices.

**Table 11**

| Physical Location Information of Photovoltaic Module | Second Physical Location Information of Photovoltaic Device |
|---|---|
| 1-1 | 1-1 |
| 1-1 | 1-2 |
| 1-1 | 1-3 |
| 1-2 | 1-4 |
| 1-2 | 1-5 |
| 1-2 | 1-6 |
| 2-1 | 2-1 |
| 2-1 | 2-2 |
| 2-1 | 2-3 |
| 2-2 | 2-4 |
| 2-2 | 2-5 |
| 2-2 | 2-6 |

According to Table 10 and Table 11, the matching first physical location information and second physical location information of the photovoltaic devices may be found, thereby establishing a mapping relationship between the photovoltaic devices and the photovoltaic modules. Therefore, by associating the device information of the photovoltaic devices with the physical location information of the photovoltaic modules, a layout diagram as shown in Table 12 can be obtained.

**Table 12**

| | | | | | |
|---|---|---|---|---|---|
| xxxxxx01 | xxxxxx02 | xxxxxx03 | xxxxxx04 | xxxxxx05 | xxxxxx06 |
| xxxxxx07 | xxxxxx08 | xxxxxx09 | xxxxxx10 | xxxxxx11 | xxxxxx12 |

In an embodiment, in step 601, the device information and the first physical location information of each photovoltaic device may be acquired manually. By manually acquiring the device information and the first physical location information of each photovoltaic device, the positioning of the photovoltaic devices can be achieved quickly and conveniently, which is easier to implement.

In a specific embodiment, the device information and the first physical location information of each of the plurality of photovoltaic devices may be acquired by scanning device identifiers of the plurality of photovoltaic devices sequentially based on physical locations of the plurality of photovoltaic devices.

For example, one row of the photovoltaic devices in the photovoltaic device array may be selected, and the device identifiers of the photovoltaic devices in the row may be scanned in order to input the device information. After the scanning of the row is completed, a next row of photovoltaic devices may be selected, and the scanning operation may be repeated until the scanning and inputting of the device information of all photovoltaic devices is completed. Since the input order of the device information of the photovoltaic devices corresponds to the physical location information of the photovoltaic devices, the device information and the first physical location information of each photovoltaic device may be acquired based on the device information of the photovoltaic devices and the input order thereof.

In another specific embodiment, the device information and the first physical location information of each photovoltaic device may also be acquired by identifying an information identification diagram of the photovoltaic power generation system. The information identification diagram may include at least one cell, and each of the at least one cell may include physical location information and a device identifier of a corresponding one of the plurality of photovoltaic devices.

For example, an information identification diagram template may include a table region, and each cell in the table may be configured to affix a device identifier of a corresponding photovoltaic device. The row and column position information of the cells and the physical location information of the photovoltaic devices may have a one-to-one mapping relationship. For example, each row of cells may represent one row of photovoltaic devices, and a sequence number of a row of photovoltaic devices may be a row number, and a column number of a cell may represent a sorting number of a corresponding photovoltaic device in the photovoltaic device group. The device identifiers of all the photovoltaic devices may be sequentially affixed into the cells of the information identification diagram template according to the mapping relationship, thereby acquiring the information identification diagram.

Each region of the information identification diagram may include the physical location information and the device identifier of a corresponding photovoltaic device. An electronic device may be used to identify the device identifier of each photovoltaic device in the information identification diagram, to acquire the device information; and to identify the row and column location information of the cell in which each device identifier is located, and to acquire the first physical location information of each photovoltaic device based on the one-to-one mapping between the row and column location information of a cell in the information identification diagram and the physical location information of the photovoltaic devices.

It should be understood that although various steps in the flowchart are displayed in sequence as indicated by the arrows, these steps are not necessarily performed in sequence in the order indicated by the arrows. Unless expressly stated herein, the execution of these steps is not strictly limited in sequence, and these steps may be performed in other orders. Moreover, at least a part of the steps in the flowcharts related to the embodiments described above may include a plurality of steps or a plurality of stages, which are not necessarily performed at the same time, but may be executed at different times. The execution order of these sub-steps or stages is also not necessarily sequential, but may be performed alternately or interleaved with other steps or at least a part of the steps or stages of other steps.

In an embodiment, as shown in FIG. 13, a layout diagram generation apparatus, applied to a photovoltaic power generation system, is provided in the present invention. The photovoltaic power generation system includes at least one photovoltaic module and at least one photovoltaic device group. Each of the at least one photovoltaic module includes a plurality of photovoltaic cell substrings. Each of the at least one photovoltaic device group includes a plurality of photovoltaic devices each connected to at least one of the plurality of photovoltaic cell substrings. The layout diagram generation apparatus includes a first acquisition module 1301, a second acquisition module 1302, and a generation module 1303.

The first acquisition module 1301 is configured to acquire device information and first physical location information of each of the plurality of photovoltaic devices.

The second acquisition module 1302 is configured to acquire physical location information of each of the at least one photovoltaic module and second physical location information of one of the plurality of photovoltaic devices connected to the photovoltaic module. The first physical location information and the second physical location information of each of the plurality of photovoltaic devices at least partially correspond to each other and at least include an arrangement number of the photovoltaic device in a photovoltaic device array.

The generation module 1303 is configured to generate a layout diagram of the photovoltaic power generation system based on the device information, the first physical location information, the second physical location information of each of the plurality of photovoltaic devices, and the physical location information of each of the at least one photovoltaic module.

In this embodiment, the device information and the first physical location information of each photovoltaic device are acquired by the first acquisition module, the physical location information of each photovoltaic module and the second physical location information of the photovoltaic device connected to the photovoltaic module are acquired by the second acquisition module, and the layout diagram of the photovoltaic power generation system is generated by the generation module based on the device information, the first physical location information, and the second physical location information of the photovoltaic devices, and the physical location information of the photovoltaic module. Thus, the accuracy of generating the layout diagram is improved, and the installation efficiency and the operation and maintenance efficiency of the photovoltaic power generation system are also improved.

In some embodiments, the generation module may include a third acquisition module and a generation sub-module.

The third acquisition module may be configured to acquire a mapping relationship between the device information of each of the plurality of photovoltaic devices and the physical location information of each of the at least one photovoltaic module based on a correspondence between first physical location information and second physical location information of the plurality of photovoltaic devices.

The generation sub-module may be configured to generate the layout diagram of the photovoltaic power generation system based on the mapping relationship, the device information of each of the plurality of photovoltaic devices, and the physical location information of each of the at least one photovoltaic module.

In some embodiments, the generation sub-module may further include a determination module and a binding module.

The determination module may be configured to determine at least one virtual unit corresponding to each of the plurality of photovoltaic devices in a layout diagram template based on the mapping relationship and the physical location information of each of the at least one photovoltaic module, and one of the at least one virtual unit is corresponding to one of the at least one photovoltaic module.

The binding module may be configured to bind the device information of each of the plurality of photovoltaic devices with a corresponding one of the at least one virtual unit in the layout diagram template to obtain the layout diagram of the photovoltaic power generation system.

In some embodiments, the second acquisition module, while acquiring the physical location information of each of the at least one photovoltaic module and the second physical location information of one of the plurality of photovoltaic devices connected to the photovoltaic module, may be further configured to acquire connection information of each of the at least one photovoltaic module. The connection information may include connection information between each of the at least one photovoltaic module and a port of a corresponding one of the plurality of photovoltaic devices.

The generation module may further be configured to generate the layout diagram of the photovoltaic power generation system based on the device information, the first physical location information, and the second physical location information of each of the plurality of photovoltaic devices, and the physical location information and the connection information of each of the at least one photovoltaic module.

In some embodiments, the second acquisition module may further be configured to acquire the physical location information of each of the at least one photovoltaic module and the second physical location information of one of the plurality of photovoltaic devices connected to the photovoltaic module based on a design drawing of the photovoltaic power generation system.

In some embodiments, the first acquisition module may further be configured to scan device identifiers of the plurality of photovoltaic devices sequentially based on physical locations of the plurality of photovoltaic devices, to acquire the device information and the first physical location information of each of the plurality of photovoltaic devices.

In some embodiments, the first acquisition module may further be configured to acquire the device information and the first physical location information of each of the plurality of photovoltaic devices based on an identified information identification diagram of the photovoltaic power generation system. The information identification diagram may include at least one cell, and each of the at least one cell may include physical location information and a device identifier of a corresponding one of the plurality of photovoltaic devices.

For specific limitations on the layout diagram generation apparatus, reference may be made to the limitations on the layout diagram generation method, and details are not repeated herein. Each module in the layout diagram generation apparatus described above may be implemented, in whole or in part, by software, hardware, or a combination thereof. If implemented in hardware, a corresponding processor may be provided for each module. The above modules may be embedded in or independent of a processor in a computer device in the form of hardware, or may be stored in a memory of the computer device in the form of software, such that the processor can call and execute the operations corresponding to the above modules.

In an embodiment, a layout diagram generation system is provided. The layout diagram generation system includes at least one photovoltaic module, at least one photovoltaic device group, and the layout diagram generation apparatus according to the above embodiments. Each of the at least one photovoltaic module may include a plurality of photovoltaic cell substrings, and each of the at least one photovoltaic device group may include a plurality of photovoltaic devices each connected to at least one of the plurality of photovoltaic cell substrings.

For specific limitations on the layout diagram generation system, reference may be made to the limitations on the layout diagram generation method described above, and details are not repeated herein.

In an embodiment, a computer-readable storage medium is provided, having a computer program stored thereon. The computer program, when executed by a processor, implements the steps in any of the above embodiments of the layout diagram generation method.

Those skilled in the art can understand that all or part of the processes in the above method embodiments may be implemented by a computer program to instruct related hardware, and the program may be stored in a non-volatile computer-readable storage medium. The computer program, when executed, may implement all or part of the steps of the embodiments of the methods described above. Any reference to a memory, a database, or other media used in the embodiments provided in the present invention may include at least one of a non-volatile memory and a volatile memory. The non-volatile memory may include read-only memory (ROM), magnetic tape, floppy disk, flash memory, optical memory, and the like. The volatile memory may include a random access memory (RAM), an external cache memory, or the like. By way of illustration and not limitation, the RAM may be in various forms, such as a static random access memory (SRAM) or a dynamic random access memory (DRAM).

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present invention.

The above embodiments only illustrate several implementations of the present invention, and the description thereof is specific and detailed, but cannot therefore be understood as limiting the protection scope of the present invention. It should be noted that those of ordinary skill in the art may further make variations and improvements without departing from the conception of the present invention, and these all fall within the protection scope of the present invention. Therefore, the protection scope of the present invention should be subject to the appended claims.

## Claims

1. A layout diagram generation method for a photovoltaic power generation system, applied to the photovoltaic power generation system, wherein the photovoltaic power generation system comprises at least one photovoltaic module and at least one photovoltaic device group, each of the at least one photovoltaic module comprises a plurality of photovoltaic cell substrings, and each of the at least one photovoltaic device group comprises a plurality of photovoltaic devices each connected to at least one of the plurality of photovoltaic cell substrings, **characterized in that** the layout diagram generation method comprises:
acquiring device information and first physical location information of each of the plurality of photovoltaic devices;
acquiring physical location information of each of the at least one photovoltaic module and second physical location information of one of the plurality of photovoltaic devices connected to the photovoltaic module, wherein the first physical location information and the second physical location information of each of the plurality of photovoltaic devices at least partially correspond to each other and at least comprise an arrangement number of the photovoltaic device in a photovoltaic device array; and
generating a layout diagram of the photovoltaic power generation system based on the device information, the first physical location information, the second physical location information of each of the plurality of photovoltaic devices, and the physical location information of each of the at least one photovoltaic module.

2. The layout diagram generation method of claim 1, wherein generating the layout diagram of the photovoltaic power generation system based on the device information, the first physical location information, the second physical location information of each of the plurality of photovoltaic devices, and the physical location information of each of the at least one photovoltaic module further comprises:
acquiring a mapping relationship between the device information of each of the plurality of photovoltaic devices and the physical location information of each of the at least one photovoltaic module based on a correspondence between first physical location information and second physical location information of the plurality of photovoltaic devices; and
generating the layout diagram of the photovoltaic power generation system based on the mapping relationship, the device information of each of the plurality of photovoltaic devices, and the physical location information of each of the at least one photovoltaic module.

3. The layout diagram generation method of claim 2, wherein generating the layout diagram of the photovoltaic power generation system based on the mapping relationship, the device information of each of the plurality of photovoltaic devices, and the physical location information of each of the at least one photovoltaic module further comprises:
determining at least one virtual unit corresponding to each of the plurality of photovoltaic devices in a layout diagram template based on the mapping relationship and the physical location information of each of the at least one photovoltaic module, wherein one of the at least one virtual unit is corresponding to one of the at least one photovoltaic module; and
binding the device information of each of the plurality of photovoltaic devices with a corresponding one of the at least one virtual unit in the layout diagram template to obtain the layout diagram of the photovoltaic power generation system.

4. The layout diagram generation method of claim 1, while acquiring the physical location information of each of the at least one photovoltaic module and the second physical location information of one of the plurality of photovoltaic devices connected to the photovoltaic module, the layout diagram generation method further comprises:
acquiring connection information of each of the at least one photovoltaic module, wherein the connection information comprises connection information between each of the at least one photovoltaic module and a port of a corresponding one of the plurality of photovoltaic devices; and
generating the layout diagram of the photovoltaic power generation system based on the device information, the first physical location information, and the second physical location information of each of the plurality of photovoltaic devices, and the physical location information and the connection information of each of the at least one photovoltaic module.

5. The layout diagram generation method of claim 1, wherein acquiring the physical location information of each of the at least one photovoltaic module and the second physical location information of one of the plurality of photovoltaic devices connected to the photovoltaic module further comprises:
acquiring the physical location information of each of the at least one photovoltaic module and the second physical location information of one of the plurality of photovoltaic devices connected to the photovoltaic module based on a design drawing of the photovoltaic power generation system.

6. The layout diagram generation method of claim 1, wherein acquiring the device information and the first physical location information of each of the plurality of photovoltaic devices further comprises:
scanning device identifiers of the plurality of photovoltaic devices sequentially based on physical locations of the plurality of photovoltaic devices, to acquire the device information and the first physical location information of each of the plurality of photovoltaic devices.

7. The layout diagram generation method of claim 1, wherein acquiring the device information and the first physical location information of each of the plurality of photovoltaic devices further comprises:
acquiring the device information and the first physical location information of each of the plurality of photovoltaic devices based on an identified information identification diagram of the photovoltaic power generation system, wherein the information identification diagram comprises at least one cell, and each of the at least one cell comprises physical location information and a device identifier of a corresponding one of the plurality of photovoltaic devices.

8. A layout diagram generation apparatus, applied to a photovoltaic power generation system, wherein the photovoltaic power generation system comprises at least one photovoltaic module and at least one photovoltaic device group, each of the at least one photovoltaic module comprises a plurality of photovoltaic cell substrings, and each of the at least one photovoltaic device group comprises a plurality of photovoltaic devices each connected to at least one of the plurality of photovoltaic cell substrings, **characterized in that** the layout diagram generation apparatus comprises a first acquisition module, a second acquisition module, and a generation module, wherein
the first acquisition module is configured for acquiring device information and first physical location information of each of the plurality of photovoltaic devices;
the second acquisition module is configured for acquiring physical location information of each of the at least one photovoltaic module and second physical location information of one of the plurality of photovoltaic devices connected to the photovoltaic module, wherein the first physical location information and the second physical location information of each of the plurality of photovoltaic devices at least partially correspond to each other and at least comprise an arrangement number of the photovoltaic device in a photovoltaic device array; and
the generation module is configured for generating a layout diagram of the photovoltaic power generation system based on the device information, the first physical location information, the second physical location information of each of the plurality of photovoltaic devices, and the physical location information of each of the at least one photovoltaic module.

9. The layout diagram generation apparatus of claim 8, wherein the generation module further comprises a third acquisition module and a generation sub-module,
the third acquisition module is configured for acquiring a mapping relationship between the device information of each of the plurality of photovoltaic devices and the physical location information of each of the at least one photovoltaic module based on a correspondence between first physical location information and second physical location information of the plurality of photovoltaic devices; and
the generation sub-module is configured for generating the layout diagram of the photovoltaic power generation system based on the mapping relationship, the device information of each of the plurality of photovoltaic devices, and the physical location information of each of the at least one photovoltaic module.

10. The layout diagram generation apparatus of claim 9, wherein the generation sub-module further comprises a determination module and a binding module,
the determination module is configured for determining at least one virtual unit corresponding to each of the plurality of photovoltaic devices in a layout diagram template based on the mapping relationship and the physical location information of each of the at least one photovoltaic module, wherein one of the at least one virtual unit is corresponding to one of the at least one photovoltaic module; and
the binding module is configured for binding the device information of each of the plurality of photovoltaic devices with a corresponding one of the at least one virtual unit in the layout diagram template to obtain the layout diagram of the photovoltaic power generation system.

11. The layout diagram generation apparatus of claim 8, while acquiring the physical location information of each of the at least one photovoltaic module and the second physical location information of one of the plurality of photovoltaic devices connected to the photovoltaic module, the second acquisition module is further configured for acquiring connection information of each of the at least one photovoltaic module, wherein the connection information comprises connection information between each of the at least one photovoltaic module and a port of a corresponding one of the plurality of photovoltaic devices; and
the generation module is further configured for generating the layout diagram of the photovoltaic power generation system based on the device information, the first physical location information, and the second physical location information of each of the plurality of photovoltaic devices, and the physical location information and the connection information of each of the at least one photovoltaic module.

12. The layout diagram generation apparatus of claim 8, wherein the second acquisition module is further configured for acquiring the physical location information of each of the at least one photovoltaic module and the second physical location information of one of the plurality of photovoltaic devices connected to the photovoltaic module based on a design drawing of the photovoltaic power generation system.

13. The layout diagram generation apparatus of claim 8, wherein the first acquisition module is further configured for scanning device identifiers of the plurality of photovoltaic devices sequentially based on physical locations of the plurality of photovoltaic devices, to acquire the device information and the first physical location information of each of the plurality of photovoltaic devices.

14. The layout diagram generation apparatus of claim 8, wherein the first acquisition module is further configured for acquiring the device information and the first physical location information of each of the plurality of photovoltaic devices based on an identified information identification diagram of the photovoltaic power generation system, wherein the information identification diagram comprises at least one cell, and each of the at least one cell comprises physical location information and a device identifier of a corresponding one of the plurality of photovoltaic devices.

15. A layout diagram generation system, **characterized by** comprising at least one photovoltaic module, at least one photovoltaic device group, and the layout diagram generation apparatus of any one of claims 8 to 14, wherein each of the at least one photovoltaic module comprises a plurality of photovoltaic cell substrings, and each of the at least one photovoltaic device group comprises a plurality of photovoltaic devices each connected to at least one of the plurality of photovoltaic cell substrings.

16. A computer readable storage medium having a computer program stored thereon, **characterized in that** the computer program, when executed by a processor, implements steps of the layout diagram generation method of any one of claims 1 to 7.
